# EUROPÄISCHE PATENTSCHRIFT

(11) **EP 2 469 782 B1**
(45) Veröffentlichungstag und Bekanntmachung des Hinweises auf die Patenterteilung: **31.03.2021**
(21) Anmeldenummer: 10016003.5
(22) Anmeldetag: 23.12.2010
(51) Int. Cl.: H03K 17/691, H04L 25/02

(54) **Schaltunfsanordnung zur Übertragung von Signalen**
Switch assembly for transferring signals
Agencement de commutation pour la transmission de signaux

(43) Veröffentlichungstag der Anmeldung: 27.06.2012
(73) Patentinhaber: Murrelektronik GmbH, 71570 Oppenweiler (DE)
(72) Erfinder: Bauermeister, Ralf, 71720 Oberstenfeld (DE); Rödiger, Jonny, 71540 Murrhardt (DE); Petri, Doerthe, 71522 Backnang (DE)
(74) Vertreter: Wasmuth, Rolf

(56) Entgegenhaltungen:
- WO-A1-81/00658
- DE-A1- 3 210 509
- US-A- 4 425 663
- US-A1- 2005 036 604
- US-A1- 2008 069 249

## Beschreibung

Die Erfindung bezieht sich auf eine Schaltungsanordnung zur Übertragung von Signalen der im Oberbegriff des Anspruchs 1 angegebenen Gattung.

Aus der DE 32 10 509 A1 ist eine Schaltungsanordnung mit einer Koppeleinrichtung zur potenzialfreien Übertragung digitaler elektrischer Steuersignale bekannt. Diese Schaltungsanordnung umfasst Ansteuerklemmen, an denen Spannungssignale angelegt werden. Diese Spannungssignale werden in eine Impulsfolge umgesetzt, die einer Primärwicklung eines Ringkernübertragers zugeführt wird. Entsprechend dieser Impulsfolge wird in einer Sekundärwicklung des Ringkernübertragers eine Impulsfolge induziert, mit gleicher Spannung wie primärseitig. In einem an die Sekundärwicklung angeschlossenen Gleichrichter wird die Spannung gleichgerichtet und von dem Gleichrichter einem Gate eines Feldeffekttransistors (FET) zugeführt, der als Schalter zur Verbindung von Leistungsklemmen dient.

Die US 2005/0036604 A1 beschreibt eine Schalteinrichtung für einen Fernsprechanschluss beinhaltend eine kraftquellenseitige Schaltung, die fähig ist, mit einer telefonleitungsseitigen Schaltung digital zu kommunizieren. Diese digitale Kommunikation zwischen den genannten Schaltungen umfasst einen digitalen Datenstrom durch eine Trennwand. Weiter ist eine Codier- und Decodierschaltung mit dem digitalen Datenstrom verbunden, um codierte digitale Signale zu generieren und zu übertragen und diese Signale jenseits der Trennwand zu empfangen.

Der vorliegenden Erfindung liegt die Aufgabe zugrunde, eine Schaltungsanordnung der eingangs genannten Gattung zu schaffen, mit der Unabhängig von der Frequenz des Ansteuersignals eine Übertragung mit hoher Taktfrequenz und schneller Ansprechzeit erfolgt.

Diese Aufgabe wird durch eine Schaltungsanordnung mit den Merkmalen des Anspruchs 1 gelöst.

In Ausgestaltung der Erfindung kann das erste Gatter ein NAND-Gatter oder ein Schmitt-Trigger sein. Gemäß einer bevorzugten Weiterbildung des Grundgedankens der Erfindung ist vorgesehen, dass das Bauelement zur Invertierung des Signals aus einem weiteren invertierenden Gatter besteht. Durch die Invertierung des Signals ergibt sich eine von dem induktiven Übertrager übertragbare Spannung, die in dem nachgeschalteten Gleichrichter wieder in eine Gleichspannung umgeformt wird. Es ist weiter von Vorteil, dass an einem Ausgang des ersten Gatters die Eingänge eines zweiten Gatters angeschlossen sind und dessen Ausgang mit Eingängen des weiteren Gatters verbunden ist. Diese dem ersten Gatter folgenden Gatter dienen der Flankenversteilerung, wodurch sich ein exaktes Rechtecksignal ergibt.

Vorzugsweise arbeitet die Schaltungsanordnung mit einer an den Ansteuerklemmen anliegenden Spannung, die im Bereich von 14 V bis 30 V liegt, wobei es sich um eine Gleichspannung oder ein digitales Signal mit einer Frequenz bis 30 kHz handeln kann. Der Spannungsregler ist so ausgelegt, dass er die Versorgungsspannung auf 14 V begrenzt. In weiterer Ausgestaltung der Schaltungsanordnung ist es zweckmäßig, dass das erste Gatter einen Schwingkreis darstellt, dessen Frequenz über die Kombination aus Widerstand und Kondensator definiert wird, wobei typischer Weise eine Frequenz von f = 1,7 MHz eingestellt wird. Das Hochfrequenzsignal hat durch die Hysterese im ersten Gatter annähernd die Form eines Rechtecksignals, das durch die weiteren Gatter zu einem exakten Rechtecksignal geformt wird.

Es ist außerdem von Vorteil, eine Betriebsanzeige vorzusehen, die auf einfache Weise dadurch gestaltet sein kann, dass an einem Anschluss der Betriebsspannung eines der Gatter eine Leuchtdiode angeschlossen ist. Der Gleichrichter besteht vorzugsweise aus einer vier Dioden umfassenden Brückenschaltung, so dass eine Zweiweggleichrichtung erfolgt und somit beide Halbwellen gleichgerichtet werden. In einer Ausführungsform ist vorgesehen, dass eine Gleichstromklemme der Brückenschaltung direkt mit dem Gate des FET und die andere Gleichstromklemme mit dem Source-Anschluss des FET verbunden ist. Alternativ hierzu ist es auch möglich, dass zwischen einer Gleichstromklemme der Brückenschaltung und das Gate des FET ein Transistor geschaltet ist, über den das Gate ansteuerbar ist. Um die im FET vorhandene Kapazität zu entladen, kann zwischen dem Gate und dem Source-Anschluss des FET ein Widerstand angeschlossen oder ein Transistor vorgesehen sein. Außerdem ist es zweckmäßig, dass der Übertrager auf einer Platine als Leiterbahn ausgeführt ist und ein Ferritkern zur magnetischen Kopplung eingesetzt ist.

Ausführungsbeispiele der Erfindung sind nachstehend anhand der Zeichnungen näher erläutert. In der Zeichnung zeigt:
- Fig. 1: eine Schaltung zur Übertragung eines elektrischen Signals mittels induktiver Kopplung,
- Fig. 2: ein Impulsdiagramm,
- Fig. 3: ein Gatter mit Anschlüssen für die Betriebsspannung,
- Fig. 4: eine Ausführungsvariante der Schaltung zur Ansteuerung des Feldeffekttransistors.

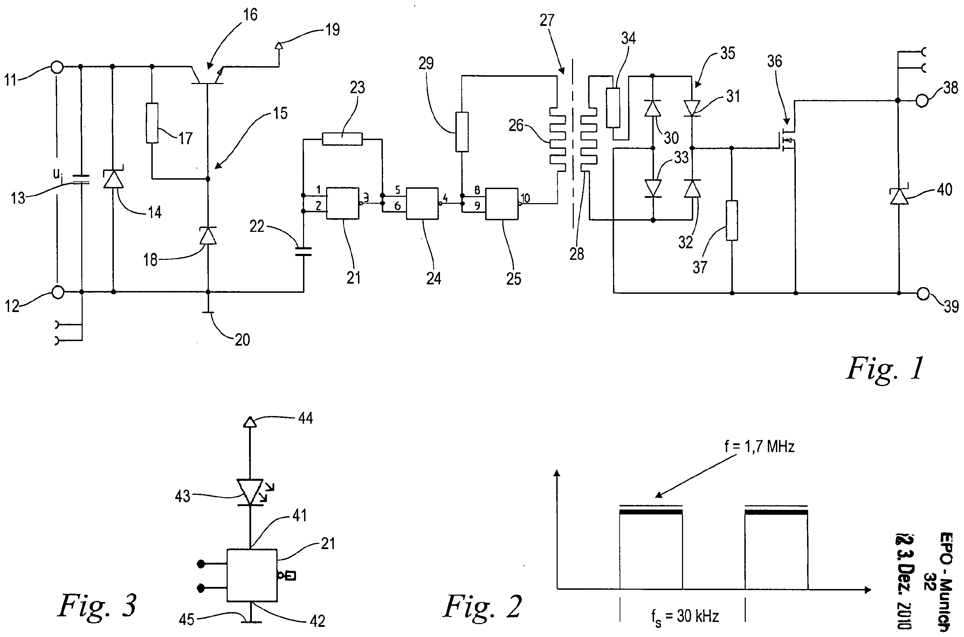

Die Schaltung in Fig. 1 weist Ansteuerklemmen 11 und 12 auf, an denen ein Schaltsignal angelegt werden kann, beispielsweise eine getaktete oder konstante Gleichspannung von 24 V. Zwischen die Ansteuerklemmen 11 und 12 ist ein Kondensator 13 geschaltet und parallel zu diesem eine Zener-Diode 14, wobei deren Katode mit der Ansteuerklemme 11 und deren Anode mit der Ansteuerklemme 12 verbunden sind.

Parallel zu dem Kondensator 13 und der Zener-Diode 14 ist ein Spannungsregler 15 geschaltet, der aus einem Transistor 16, einem Widerstand 17 und einer Zener-Diode 18 besteht. Dabei ist der Kollektor des Transistors 16 mit der Ansteuerklemme 11 und die Basis mit der Katode der Zener-Diode 18 verbunden, die anodenseitig mit der Ansteuerklemme 12 sowie einem Masseanschluss 20 verbunden ist. Der Widerstand 17 liegt zwischen dem Kollektor und der Basis des Transistors 16. Der Emitter ist mit einer Spannungsquelle 19 verbunden, die eine konstante Gleichspannung liefert. Der Spannungsregler 15 begrenzt die Eingangsspannung auf 14 V.

Ein erstes invertierendes Gatter 21 ist im Ausführungsbeispiel als NAND-Gatter mit Funktion als Schmitt-Trigger ausgeführt und mit seinen Eingängen 1, 2 über einen Kondensator 22 mit der Anode der Zener-Diode 18 verbunden, und der Ausgang 3 ist über einen Widerstand 23 zur Rücckopplung mit dem invertierenden Eingang 1 des Gatters 21 verbunden. Das erste Gatter 21 stellt einen Schwingkreis dar, dessen Frequenz über die Kombination mit Widerstand 23 und Kondensator 22 definiert wird. Das erste Gatter 21 erzeugt somit durch die Hysterese ein am Ausgang 3 anstehendes, im Wesentlichen rechteckiges Signal. Das erste Gatter 21 mit der Rückführung des Ausgangssignals über den Widerstand 23 zu dem invertierenden Eingang und dem vorgeschalteten Kondensator 22 wirkt als astabilier Multivibrator und erzeugt ein Hochfrequenzsignal, das typischer Weise auf die Frequenz f = 1,7 MHz eingestellt wird. Das Signal am Ausgang 3 wird den Eingängen 5, 6 eines zweiten Gatters 24 zugeführt. Das zweite Gatter 24 ist im Ausführungsbeispiel ebenfalls ein NAND-Gatter mit Schmitt-Trigger Funktion , an dessen Ausgang 4 Eingänge 8, 9 eines dritten Gatters 25, ebenfalls ein NAND-Gatter oder Schmitt-Trigger, angeschlossen sind. Die beiden Gatter 24 und 25 dienen zur Flankenversteilerung des Rechtecksignals.

Der Ausgang 10 des dritten Gatters 25 ist mit einer Primärwicklung 26 eines induktiven Übertragers 27 verbunden, deren anderes Ende unter Zwischenschaltung eines Widerstands 29 mit dem Ausgang 4 des zweiten Gatters 24 bzw. den Eingängen 8, 9 des dritten Gatters 25 verbunden ist. Am Ausgang 4 des zweiten Gatters und Ausgang 10 des dritten Gatters 25 liegt je ein invertiertes Rechtecksignal einer Frequenz f = 1,7 MHz an. Es ist somit eine rechteckige Wechselspannung, welche auf die Primärwicklung 26 des Übertragers 27 gegeben wird. Der induktive Übertrager 27 erzeugt in einer Sekundärwicklung 28 die gleiche Spannung, die an der Primärwicklung 26 anliegt. Die Primärwicklung 26 wird durch das Gatter 25 aktiv umgepolt und erhält somit immer die interne Versorgungsspannung. Dadurch wird die maximale Leistung im Übertrager 27 erzielt.

Die Sekundärwicklung 28 ist mit einem aus vier Dioden 30, 31, 32 und 33 gebildeten Gleichrichter 35 verbunden, wobei zwischen einem Ende der Sekundärwicklung 28 und die Gleichrichterbrücke ein Widerstand 34 geschaltet ist. Im Gleichrichter 35 erfolgt eine Zweiweggleichrichtung, wodurch beide Halbwellen gleichgerichtet werden. Eine der Gleichstromklemmen des Gleichrichters 35 ist mit dem Source-Anschluss eines Feldeffekt-Transistors 36 verbunden und die andere Gleichstromklemme des Gleichrichters 35 ist an das Gate geschaltet. Die Welligkeit nach dem Brückengleichrichter wird durch die interne Kapazität des FET 36 ausreichend geglättet, so dass der FET 36 durchsteuert. Der Drain-Anschluss des FET 36 ist mit einer Leistungsschaltklemme 38 verbunden, an der eine positive Spannung anliegt. Die Kapazität des FET 36 glättet die von dem Gleichrichter abgegebene pulsierende Wechselspannung, wodurch der FET leitend wird. Zwischen das Gate und den Source-Anschluss des FET ist ein Widerstand 37 geschaltet, der dazu dient, die im FET 36 enthaltene Kapazität zu entladen.

An den Source-Anschluss des FET 36 ist auch eine Leistungsklemme 39 geschaltet, an die ein Verbraucher angeschlossen ist. An die Leistungsklemmen 38 ist eine Katode einer Zener-Diode 40 angeschlossen, deren Anode mit der Leistungsklemme 39 verbunden ist.

Bei Anliegen einer Versorgungsspannung Uᵢ an den Ansteuerklemmen 11, 12 arbeitet der induktive Übertrager zum Schalten eines Verbrauchers an eine Spannungsquelle. Die Versorgungsspannung Uᵢ hat vorzugsweise eine Nennspannung von 24 V, das System arbeitet jedoch im Bereich von Uᵢ = 14 V bis 30 V. Uᵢ kann eine Gleichspannung oder eine pulsierende Gleichspannung bis 30 kHz sein. Die Versorgungsspannung ist gleichzeitig Taktgenerierungsspannung. Die Versorgungsspannung wird im Spannungsregler 15 auf eine konstante Spannung von 14 V heruntergeregelt, die für die Gatter 21, 24, 25 erforderlich ist. Bei steigender Versorgungsspannung Uᵢ schwingt der Oszillator an, so dass ein Signal übertragen wird.

Im ersten Gatter 21 mit Kombination von Widerstand 23 und Kondensator 22 wird das Hochfrequenzsignal von f = 1,7 MHz erzeugt, das annähernd die Form eines Rechtecksignals hat. Die nachgeschalteten Gatter 24, 25 dienen zur Flankenversteilerung und durch Invertieren des Signals im dritten Gatter 25 wird an die Primärwicklung 26 des Übertragers 27 eine Wechselspannung geliefert, wobei induktiv in der Sekundärwicklung 28 die gleiche Spannung mit der Frequenz f = 1,7 MHz erzeugt wird. Diese Wechselspannung wird in dem nachgeschalteten Gleichrichter 35 gleichgerichtet, wobei durch die Zweiweggleichrichtung als Signal eine unmittelbare Folge positiver Halbwellen entsteht. Dieses Signal dient zur Ansteuerung des FET 36, der die Verbindung zwischen den Leistungsschaltklemmen 38 und 39 schließt. Der FET 36 benötigt keine Hilfsspannung, die übertragene Energie reicht für die Funktion aus.

Liegt an den Ansteuerklemmen 11, 12 keine Spannung Uᵢ an, so arbeitet die gesamte Schaltung nicht. Somit wird auch kein Strom verbraucht.

In Fig. 2 ist ein Impulsdiagramm gezeigt, in dem zwei Steuerimpulse dargestellt sind, wobei als Beispiel die Frequenz fₛ = 30 kHz beträgt. Während des Steuerimpulses erzeugt das erste Gatter, das als astabiler Multivibrator wirkt, das zu Fig. 1 beschriebene Hochfrequenzsignal von f = 1,7 MHz.

In Fig. 3 ist ein Gatter, beispielsweise das erste Gatter 21 mit Anschlüssen 41, 42 für die Betriebsspannung des Gatters dargestellt. Der Anschluss 41 ist mit der Katode einer Leuchtdiode 43 verbunden, die anodenseitig an eine Spannungsquelle 44 geschaltet ist. Der Anschluss 42 ist mit einem Masseanschluss 45 verbunden. Die Leuchtdiode 43 wird beim Betrieb des Gatters 21 vom Strom durchflossen und dient damit als Betriebsanzeige des in Fig. 1 gezeigten Systems.

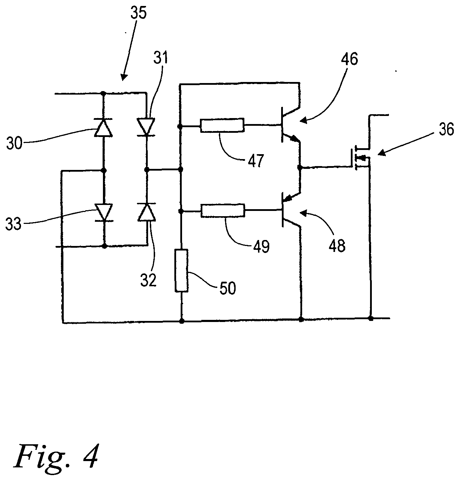

Die Fig. 4 zeigt eine Ausführungsvariante der Schaltung zur Ansteuerung des FET 36. Der Gleichrichter 35 aus der Brückenschaltung der Dioden 30 bis 33 entspricht demjenigen der Fig. 1. Eine Gleichstromklemme des Gleichrichters 35 ist mit dem Source-Anschluss des FET 36 verbunden, wie dies ebenso in Fig. 1 der Fall ist. In Fig. 4 ist an die andere Gleichstromklemme des Gleichrichters 35 der Kollektor eines Transistors 46 geschaltet, dessen Emitter mit dem Gate 4 des FET 36 verbunden ist. Die Basis des Transistors 46 ist über einen Widerstand 47 mit der Gleichstromklemme des Gleichrichters 35 verbunden, an die auch der Kollektor des Transistors 46 geschaltet ist. Mit dem Gate des FET 36 ist auch der Emitter eines Transistors 48 verbunden, dessen Kollektor mit dem Source-Anschluss des FET verbunden ist. Die Basis des Transistors 48 ist über einen Widerstand 49 an die Gleichstromquelle geschaltet, an der auch die Basis des Transistors 46 liegt. Zwischen den Widerständen 47, 49 und der Verbindungsleitung vom Gleichrichter 35 zum Source-Anschluss des FET 36 ist ein Widerstand 50 geschaltet. Der Transistor 46 dient zur Ansteuerung des FET 36, das heißt, bei einer entsprechenden Ausgangsspannung am Gleichrichter 35 wird die Basis des Transistors 46 angesteuert, so dass dieser durchschaltet und ein Strom vom Kollektor zum Emitter fließt und damit das Gate des FET 36 angesteuert wird. Sobald am Gleichrichter 35 die Ausgangsspannung einen vorgegebenen Wert unterschreitet, sperrt der Transistor 46 und die Basis des Transistors 48 wird angesteuert, so dass dieser durchschaltet und somit ein Strom vom Gate des FET 36 zu der zum Source-Anschluss führenden Verbindungsleitung fließt. Auf diese Weise wird das Gate mit dem Source-Anschluss kurzgeschlossen, wodurch ein Entladen der Kapazität im FET 36 erfolgt. Im Übrigen ist das System gleich demjenigen der Fig. 1.

Mit der vorstehend beschriebenen Schaltung zu Fig. 1 bzw. der Ausführungsvariante gemäß Fig. 4 können Steuerimpulse bis zu 30 kHz übertragen werden. Am Ausgang ist keine zusätzliche Betriebsspannung erforderlich, die übertragene Energie reicht zur Schaltung des FET 36 und damit zur Verbindung der Leistungsschaltklemmen 38, 39 aus. Durch die hohe Taktfrequenz ist die Ansprechzeit sehr gering. Als induktiver Übertrager 27 kommt beispielsweise ein Leiterplattentrafo in Betracht, so dass die Schaltung insgesamt kostengünstig ist. Es sind keine alternden oder verschleißenden Bauteile eingesetzt, so dass eine lange Lebensdauer gegeben ist. Die Schaltung ist als Ersatz für Relais oder Optokoppler vorgesehen.

## Patentansprüche

1. Schaltungsanordnung zur Übertragung von Signalen, wobei Ansteuerklemmen (11, 12) zum Anlegen einer Spannung (Uᵢ) und eine nachgeordnete Baugruppe zur Erzeugung einer Impulsfolge vorgesehen sind, wobei diese Baugruppe ausgangsseitig an eine Primärwicklung (26) eines induktiven Übertragers (27) angeschlossen und eine Sekundärwicklung (28) des induktiven Übertragers (27) mit einem Gleichrichter (35) verbunden ist, an dem ausgangsseitig ein Gate eines FET (36) angeschlossen ist und der FET (36) als Schalter zwischen Leistungsschaltklemmen (38, 39) dient,
**dadurch gekennzeichnet, dass** mit den Ansteuerklemmen (11, 12) ein Spannungsregler (15) verbunden ist und die Baugruppe zur Erzeugung der Impulsfolge ein mit einer Rückkopplung versehenes erstes invertierendes Gatter (21) und ein weiteres Bauelement zur Invertierung des Signals umfasst, wobei das invertierende Gatter (21) eingangsseitig über einen Kondensator (22) mit dem Spannungsregler (15) verbunden ist.

2. Schaltungsanordnung nach Anspruch 1,
**dadurch gekennzeichnet, dass** das invertierende Gatter (21) ein NAND-Gatter oder ein Schmitt-Trigger ist.

3. Schaltungsanordnung nach Anspruch 1 oder 2,
**dadurch gekennzeichnet, dass** das weitere Bauelement zur Invertierung des Signals aus einem weiteren Gatter (25) besteht.

4. Schaltungsanordnung nach Anspruch 3,
**dadurch gekennzeichnet, dass** an einem Ausgang (3) des ersten Gatters (21) die Eingänge (5, 6) eines zweiten Gatters (24) angeschlossen sind und dessen Ausgang (4) mit Eingängen (8, 9) des weiteren Gatters (25) verbunden ist.

5. Schaltungsanordnung nach einem der Ansprüche 1 bis 4,
**dadurch gekennzeichnet, dass** die an den Ansteuerklemmen (11, 12) anliegende Spannung (Uᵢ) in einem Bereich von 14 V bis 30 V liegt.

6. Schaltungsanordnung nach Anspruch 5,
**dadurch gekennzeichnet, dass** die Spannung (Uᵢ) ein digitales Signal mit einer maximalen Frequenz fₛ = 30 kHz ist.

7. Schaltungsanordnung nach einem der Ansprüche 1 bis 6,
**dadurch gekennzeichnet, dass** der Spannungsregler (15) die interne Versorgungsspannung auf 14 V begrenzt.

8. Schaltungsanordnung nach einem der Ansprüche 1 bis 7,
**dadurch gekennzeichnet, dass** das erste Gatter (21) einen Schwingkreis darstellt, dessen Frequenz über die Kombination mit Widerstand (23) und Kondensator (22) definiert wird, wobei typischer Weise eine Frequenz von f = 1,7 MHz eingestellt wird.

9. Schaltungsanordnung nach einem der Ansprüche 1 bis 8,
**dadurch gekennzeichnet, dass** an der Betriebsspannung des Gatters (21, 24, 25) eine Leuchtdiode (43) zur Anzeige der Eingangsspannung (Uᵢ) angeschlossen ist.

10. Schaltungsanordnung nach einem der Ansprüche 1 bis 9,
**dadurch gekennzeichnet, dass** der Gleichrichter (15) eine aus vier Dioden (30, 31, 32, 33) gebildete Brückenschaltung ist.

11. Schaltungsanordnung nach Anspruch 10,
**dadurch gekennzeichnet, dass** eine Gleichstromklemme der Brückenschaltung direkt mit dem Gate des FET (36) und die andere Gleichstromklemme mit dem Source-Anschluss des FET (36) verbunden ist.

12. Schaltungsanordnung nach Anspruch 10,
**dadurch gekennzeichnet, dass** zwischen einer Gleichstromklemme der Brückenschaltung und das Gate des FET (36) ein Transistor (46) geschaltet ist, über den das Gate ansteuerbar ist.

13. Schaltungsanordnung nach Anspruch 10,
**dadurch gekennzeichnet, dass** zwischen dem Gate und dem Source-Anschluss des FET (36) ein Widerstand angeschlossen ist.

14. Schaltungsanordnung nach Anspruch 10,
**dadurch gekennzeichnet, dass** zwischen dem Gate und dem Source-Anschluss des FET (36) ein Transistor (48) vorgesehen ist.

15. Schaltungsanordnung nach einem der Ansprüche 3 bis 14,
**dadurch gekennzeichnet, dass** die Primärwicklung (26) durch das Gatter (25) aktiv umgepolt wird und somit immer die gesamte interne Versorgungsspannung erhält, wodurch die maximale Leistung in dem induktiven Übertrager (27) erzielt wird.

16. Schaltungsanordnung nach einem der Ansprüche 1 bis 15,
**dadurch gekennzeichnet, dass** der induktive Übertrager (27) auf einer Platine als Leiterbahn ausgeführt ist und ein Ferritkern zur magnetischen Kopplung eingesetzt ist.

## Claims

1. Circuit assembly for the transmission of signals, wherein energising terminals (11, 12) for applying a voltage (Uᵢ) and a downstream assembly for generating a pulse sequence are provided, wherein said assembly is on the output side connected to a primary winding (26) of an inductive transducer (27) and a secondary winding (28) of the inductive transducer (27) is connected to a rectifier (35), to the output side of which a gate of a FET (36) is connected, the FET (36) serving as a switch between circuit breaking terminals (38, 39),
**characterised in that** a voltage controller (15) is connected to the energising terminals (11, 12) and the assembly for generating the pulse sequence comprises a first inverting gate (21) provided with a feedback and a further component for inverting the signal, wherein the inverting gate (21) is on the input side connected to the voltage controller (15) via a capacitor (22).

2. Circuit assembly according to claim 1,
**characterised in that** the inverting gate (21) is a NAND gate or a Schmitt trigger.

3. Circuit assembly according to claim 1 or 2,
**characterised in that** the further component for inverting the signal consists of a further gate (25).

4. Circuit assembly according to claim 3,
**characterised in that** the inputs (5, 6) of a second gate (24) are connected to an output (3) of the first gate (21), the output (4) of the second gate (24) being connected to inputs (8, 9) of the further gate (25).

5. Circuit assembly according to any of claims 1 to 4,
**characterised in that** the voltage (Uᵢ) applied to the energising terminals (11, 12) lies in a range of 14 V to 30 V.

6. Circuit assembly according to claim 5,
**characterised in that** the voltage (Uᵢ) is a digital signal with a maximum frequency fs = 30 kHz.

7. Circuit assembly according to any of claims 1 to 6,
**characterised in that** the voltage controller (15) limits the internal supply voltage to 14 V.

8. Circuit assembly according to any of claims 1 to 7,
**characterised in that** the first gate (21) represents an oscillating circuit, the frequency of which is defined via the combination of resistor (23) and capacitor (22), a frequency of f = 1.7 MHz being typically set.

9. Circuit assembly according to any of claims 1 to 8,
**characterised in that** a light-emitting diode (43) for the indication of the input voltage (Uᵢ) is connected to the operating voltage of the gate (21, 24, 25).

10. Circuit assembly according to any of claims 1 to 9,
**characterised in that** the rectifier (15) is a bridge circuit formed from four diodes (30, 31, 32, 33).

11. Circuit assembly according to claim 10,
**characterised in that** a DC terminal of the bridge circuit is directly connected to the gate of the FET (36) and the other DC terminal is connected to the source connection of the FET (36).

12. Circuit assembly according to claim 10,
**characterised in that** a transistor (46) is connected between a DC terminal of the bridge circuit and the gate of the FET (36), via which transistor (46) the gate can be controlled.

13. Circuit assembly according to claim 10,
**characterised in that** a resistor is connected between the gate and the source connection of the FET (36).

14. Circuit assembly according to claim 10,
**characterised in that** a transistor (48) is provided between the gate and the source connection of the FET (36).

15. Circuit assembly according to any of claims 3 to 14,
**characterised in that** the primary winding (26) has its polarity actively reversed by the gate (25) and thus always receives the entire internal supply voltage, whereby the maximum power is obtained in the inductive transducer (27).

16. Circuit assembly according to any of claims 1 to 15,
**characterised in that** the inductive transducer (27) is provided as a conductor on a printed circuit board and a ferrite core is used for magnetic coupling.

## Revendications

1. Agencement de circuit pour la transmission de signaux, dans lequel sont prévus des bornes de commande (11, 12) pour appliquer une tension (Uᵢ) et un ensemble disposé en aval pour générer une suite d'impulsions, dans lequel cet ensemble est raccordé côté sortie à un enroulement primaire (26) d'un transmetteur inductif (27) et un enroulement secondaire (28) du transmetteur inductif (27) est relié à un redresseur (35) auquel est raccordée côté sortie une grille d'un FET (36) et le FET (36) sert de commutateur entre des bornes de commutation de puissance (38, 39),
**caractérisé en ce qu'**un régulateur de tension (15) est relié aux bornes de commande (11, 12) et l'ensemble pour générer la suite d'impulsions comprend une première porte d'inversion (21) pourvue d'un rétrocouplage et un autre composant pour l'inversion du signal, dans lequel la porte d'inversion (21) est reliée côté entrée au régulateur de tension (15) par un condensateur (22).

2. Agencement de circuit selon la revendication 1,
**caractérisé en ce que** la porte d'inversion (21) est une porte NON-ET ou une bascule de Schmitt.

3. Agencement de circuit selon la revendication 1 ou 2,
**caractérisé en ce que** l'autre composant pour l'inversion du signal se compose d'une autre porte (25).

4. Agencement de circuit selon la revendication 3,
**caractérisé en ce qu'**à une sortie (3) de la première porte (21) sont raccordées les entrées (5, 6) d'une deuxième porte (24) et sa sortie (4) est reliée aux entrées (8, 9) de l'autre porte (25).

5. Agencement de circuit selon l'une des revendications 1 à 4,
**caractérisé en ce que** la tension (Uᵢ) appliquée aux bornes de commande (11, 12) est située dans une plage de 14 V à 30 V.

6. Agencement de circuit selon la revendication 5,
**caractérisé en ce que** la tension (Uᵢ) est un signal numérique avec une fréquence maximale fₛ = 30 kHz.

7. Agencement de circuit selon l'une des revendications 1 à 6,
**caractérisé en ce que** le régulateur de tension (15) limite la tension d'alimentation interne à 14 V.

8. Agencement de circuit selon l'une des revendications 1 à 7,
**caractérisé en ce que** la première porte (21) représente un circuit oscillant dont la fréquence est définie par la combinaison avec une résistance (23) et un condensateur (22), dans lequel d'une manière typique une fréquence f = 1,7 MHz est réglée.

9. Agencement de circuit selon l'une des revendications 1 à 8,
**caractérisé en ce qu'**à la tension de service de la porte (21, 24, 25) est raccordée une diode lumineuse (43) pour afficher la tension d'entrée (Uᵢ).

10. Agencement de circuit selon l'une des revendications 1 à 9,
**caractérisé en ce que** le redresseur (15) est un montage en pont formé de quatre diodes (30, 31, 32, 33).

11. Agencement de circuit selon la revendication 10,
**caractérisé en ce qu'**une borne de courant continu du montage en pont est reliée directement à la grille du FET (36) et l'autre borne de courant continu est reliée au raccordement source du FET (36).

12. Agencement de circuit selon la revendication 10,
**caractérisé en ce qu'**entre une borne de courant continu du montage en pont et la grille du FET (36) est monté un transistor (46) par lequel la grille est apte à être commandée.

13. Agencement de circuit selon la revendication 10,
**caractérisé en ce qu'**entre la grille et le raccordement source du FET (36) est raccordée une résistance.

14. Agencement de circuit selon la revendication 10,
**caractérisé en ce qu'**entre la grille et le raccordement source du FET (36) est prévu un transistor (48).

15. Agencement de circuit selon l'une des revendications 3 à 14,
**caractérisé en ce que** l'enroulement primaire (26) est l'objet d'une inversion de polarité active par la porte (25) et reçoit ainsi toute la tension d'alimentation interne, moyennant quoi la puissance maximale est obtenue dans le transmetteur inductif (27).

16. Agencement de circuit selon l'une des revendications 1 à 15,
**caractérisé en ce que** le transmetteur inductif (27) est réalisé sur une platine comme une piste conductrice et un noyau de ferrite pour le couplage magnétique est inséré.
